(19)

Europäisches Patentamt
European Patent Office
Office européen des brevets

(11)  **EP 3 148 045 B1**

(12)  **EUROPEAN PATENT SPECIFICATION**

(45) Date of publication and mention
of the grant of the patent:
**06.11.2019  Bulletin 2019/45**

(21) Application number: **16183849.5**

(22) Date of filing: **11.08.2016**

(51) Int Cl.:
$H02J\ 50/10^{(2016.01)}$   $H02M\ 1/12^{(2006.01)}$
$H03F\ 1/26^{(2006.01)}$   $H02M\ 3/335^{(2006.01)}$
$H03F\ 1/56^{(2006.01)}$   $H03F\ 3/195^{(2006.01)}$
$H03F\ 3/217^{(2006.01)}$   $H03F\ 3/24^{(2006.01)}$
$H02J\ 7/02^{(2016.01)}$

(54) **CONSTANT CURRENT RADIO FREQUENCY  GENERATOR FOR A WIRELESS CHARGING SYSTEM**

KONSTANTSTROM-HOCHFREQUENZGENERATOR FÜR EIN DRAHTLOSES LADESYSTEM

GÉNÉRATEUR DE RADIOFRÉQUENCES À COURANT CONSTANT POUR UN SYSTÈME DE CHARGE SANS FIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **22.09.2015  US 201514861931**

(43) Date of publication of application:
**29.03.2017  Bulletin 2017/13**

(73) Proprietor: **Intel Corporation**
**Santa Clara, CA 95054 (US)**

(72) Inventors:
• **YANG, Songnan**
**San Jose, CA 95123 (US)**

• **XIAO, Bin**
**San Ramon, CA  94582 (US)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**US-A1- 2008 180 170    US-A1- 2013 187 712**
**US-A1- 2014 091 634    US-A1- 2015 069 854**

EP 3 148 045 B1

**Description**

**Technical Field**

This disclosure relates generally to techniques for wireless charging. Specifically, this disclosure relates to providing constant current for wireless charging.

**Background Art**

A basic wireless charging system may include a wireless power transmitter unit (PTU) and a wireless power receiving unit (PRU). For example, a PTU may include a transmit (Tx) coil, and a PRU may include a receive (Rx) coil. Magnetic resonance wireless charging may employ a magnetic coupling between the Tx coil and the Rx coil. In some cases, a PRU is implemented in a device having various size chassis. In some cases, PTU is configured as a constant current source even when various size chassis change a resonant frequency of magnetic coupling between the PRU and the PTU. Wireless power transmitter units are known e.g. from US2015/069854A1, US2013/187712A1, US2014/091634A1 and US2008/180170A1.

An Alliance for Wireless Power (A4WP) based wireless charging system may rely on control of the current in the transmitter coil to achieve a designed power transfer performance. The standard specifically calls for $I_{TX}$ (current provided by the power amplifier (PA) to the coil) to be tested for compliance. The current is to be maintained as constant as possible despite large variations in the load impedance.

Typical PA topologies do not by default supply constant current radio frequency (RF) current to the load. Conventionally, the design of a power amplifier system to provide constant current behavior over varying load conditions includes a closed loop system. For example, the state of the art A4WP PA design utilizes a Class D switch mode PA topology with variable supply voltage and a feedback system to achieve constant current behavior with varying load. The PA supply voltage is adjusted based on the sampled output current to maintain a constant current behavior. Solutions like this are slow in response, complicated to implement, and may not meet all the extreme load conditions the PA may be subjected to in wireless power transfer systems. The known solutions rely on feedback to adjust the output current of the PA. These solutions are costly, slow in response, and may not be able to provide the desired coverage for a large load impedance range.

**Brief Description of the Drawings**

FIG. 1 is block diagram of a PTU to provide power to a PRU;
FIG. 2 is a schematic diagram of a device for wirelessly charging a battery;
FIG. 3a is a schematic diagram of an LC impedance transformation network;
FIG. 3b is a plot of the frequency response of the LC impedance transformation network of FIG. 3a;
FIG. 4a is a smith chart illustrating the constant power contour at plane A of FIG. 2, and ideal load line of a typical Class E switch mode PA with shunt capacitance topology;
FIG. 4b is a smith chart illustrating an ideal constant power contour for constant current behavior at the load;
FIG. 5 is a smith chart illustrating the phase shift of a simple LC impedance transformer;
FIG. 6 is a schematic diagram of a two stage low pass impedance transformation network;
FIG. 7a is a schematic diagram of a notch filter;
FIG. 7b is a schematic diagram of a circuit that is equivalent to the notch filter of FIG. 5 at fundamental frequency;
FIG. 8 is a process flow diagram of an example method for designing a switch mode power amplifier with constant current behavior;
FIG. 9 is a schematic diagram of a switch mode power amplifier based on single ended Class E with finite inductance;
FIG. 10 is a smith chart illustrating a load pull simulation of a single ended Class E with finite inductance shown in FIG. 9;
FIG. 11 is a schematic diagram of a synthesized output network;
FIG. 12 is a smith chart illustrating a simulated phase shift pattern for the network of FIG. 11, with each stage's contribution;
FIG. 13a is a plot of frequency response comparison of the combined filter of FIG. 11;
FIG. 13b is a smith chart of the measured phase shift of a prototype combined filter;
FIG. 14a is a smith chart of simulated constant power and constant efficiency contours of the combination of the switch mode PA and the synthesized output network of FIG. 11; and
FIG. 14b is a smith chart of simulated output current contours vs. A4WP certification required impedance range.

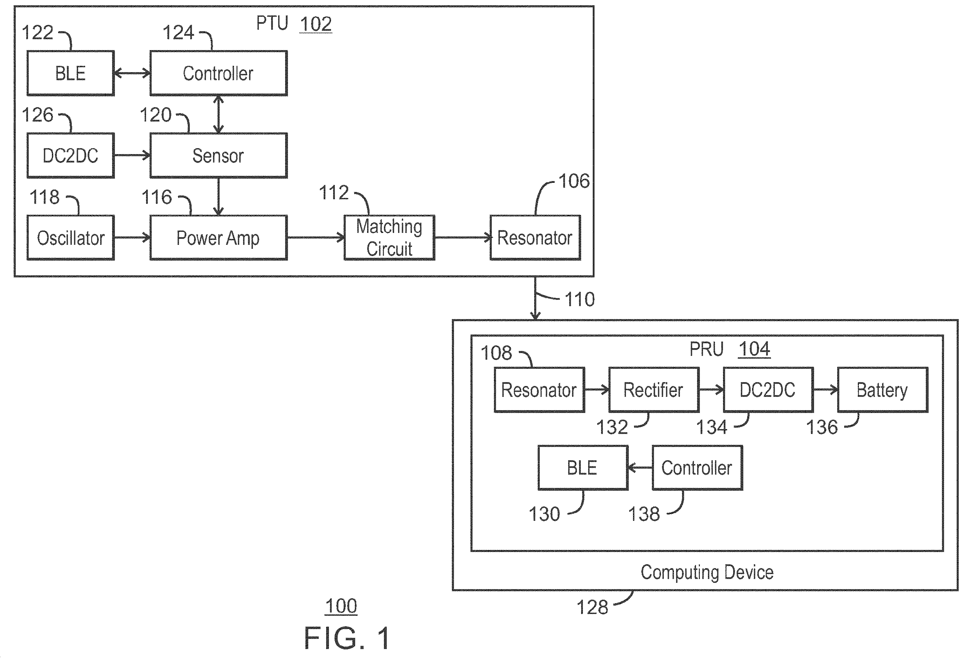

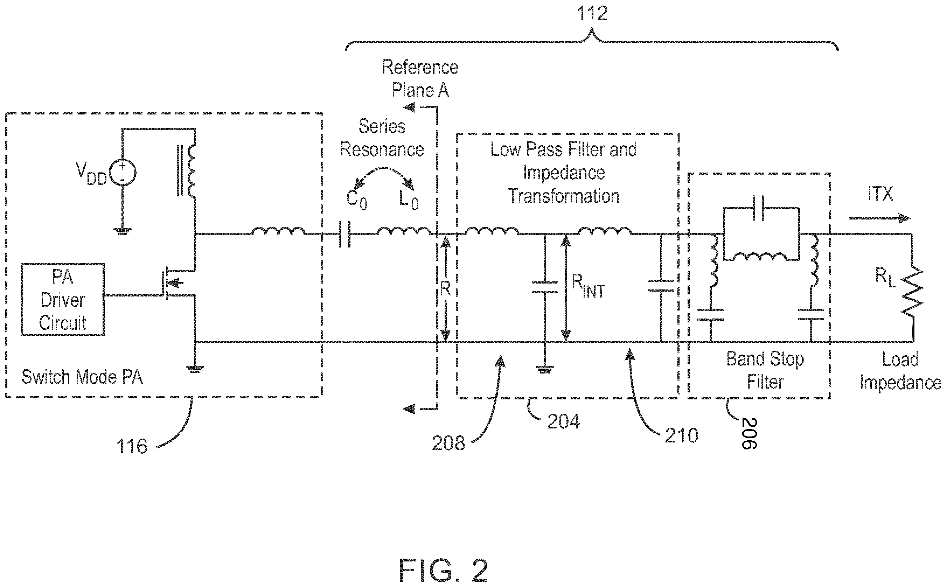

The same numbers are used throughout the disclosure and the figures to reference like components and features. Numbers in the 100 series refer to features originally found in FIG. 1; numbers in the 200 series refer to features originally found in FIG. 2; and so on.

## Description of the Aspects

The present disclosure relates generally to techniques for wireless charging. Specifically, the techniques described herein include an apparatus in a wireless power transmitting unit (PTU) having a transmitter (Tx) coil configured to generate a magnetic field. The apparatus may also include a tuning circuit for tuning the transmitter coil.

The invention is defined in the independent claims. Preferred embodiments are addressed in the dependent claims.

As discussed above, in some cases, the PTU is configured to appear as a constant current source even while various size chassis may change a resonant frequency of magnetic coupling between a wireless power receiving unit (PRU) and the PTU. For example, a mobile computing device having a PRU may have a relatively smaller metal chassis when compared to a laptop computing device.

The techniques discussed herein may be implemented using a wireless charging standard protocol, such as the specification provided by Alliance For Wireless Power (A4WP) version 1.3, November 05, 2014. A wireless power receiving (Rx) coil may be a component in a power receiving unit (PRU), while a wireless power transmission (Tx) coil may be a component in a power transmitting unit (PTU), as discussed in more detail below. However, the techniques described herein may be implemented using any other wireless charging standard protocol where applicable.

FIG. 1 is block diagram of a wireless charging arrangement 100 including a PTU to provide power to a PRU, wherein the PTU includes a resonant frequency detection circuit. A PTU 102 may couple to a PRU 104 via magnetic inductive coupling between resonators 106 and 108, as indicated by the arrow 110. The PRU 104 may be a component of a computing device 128 configured to receive charge by the inductive coupling 110. The resonator 106 may be referred to herein as a Tx coil 106 of the PTU 102. The resonator 108 may be referred to herein as an Rx coil 108 of the PRU 104.

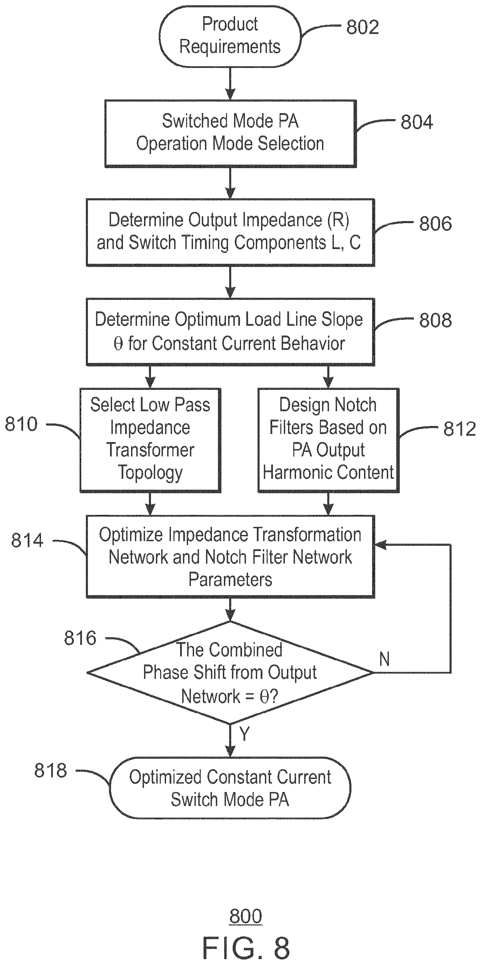

The PTU 102 may include a matching circuit 112 configured to match the impedance of the output of power amplifier 116 to the load impedance of PRU 104. Matching circuit 112 may also filter out harmonics of the current that is output by power amplifier 116, and may enable the current that is output by power amplifier 116 to be constant. The matching circuit 112 may include any suitable arrangement of electrical components such as capacitors, inductors, and other circuit elements. However, specific example embodiments of matching circuit 112 are illustrated in FIGS. 2 and 8. Other components of the PTU 102 may include an oscillator 118, a current sensor 120, a Bluetooth Low Energy (BLE) module 122, a controller 124, direct current to direct current (DC2DC) converter 126, and the like. The current sensor 120 may be an ampere meter, a volt meter, or any other sensor configured to sense load variations occurring due to inductive coupling between the PTU 102 and another object, such as the PRU 104. The sensor 120 may provide an indication of load change to the controller 124 of the PTU 102. The controller 124 may power on the power amplifier 116 configured to receive direct current (DC) from the DC2DC converter 126, and to amplify and oscillate the current. The oscillator 118 may be configured to oscillate the power provided at a given frequency.

As shown in FIG. 1, an inductive coupling 110 may occur between the Tx coil 106 and the Rx coil 108, and, as a magnetic flux associated with the inductive coupling passes through the Rx coil 108, the computing device 128 may receive power. A rectifier 132 may receive voltage having an alternating current (AC) from the Rx coil 108 and may be configured to generate a rectified voltage (Vrect) having a direct current (DC). As illustrated in FIG. 1, a DC2DC converter 134 may provide a DC output to a battery 136.

The PRU 104 may also include a controller 138 configured to initiate a wireless broadcast having wireless handshake data. As discussed above, the wireless handshake broadcast may be carried out by a wireless data transmission component such as BLE module 130.

In accordance with the present techniques, the PA 116 is a switch mode power amplifier to provide constant RF current to a varying load. A detailed design methodology is also provided to synthesize a wireless charging (A4WP) compliant, regulatory approved PA solution.

The switch mode PA 116 and its corresponding output network are configured to realize constant current behavior without feedback and dynamic adjustments. The PA output network topology and design may be such that the PA provides certain power at a predefined load impedance, provides a near constant current output to the load when the load has large resistance and reactance variations, and has low harmonics emissions, which enables the system to pass spurious emission (EMI) regulatory tests.

The simplified system described herein synthesizes a PA output network by strategically selecting the output network circuit parameters to cause the PA 116 to automatically output more power as the load impedance increases, resulting in superior constant current behavior. This simplifies the system design, reduces cost, and provides better function over a large load impedance range.

The output network is configured to present a load line (with respect to varying load resistance) to the switch mode PA 116 that aligns with the highest gradient path of the constant power contour of the PA 116. This, in turn, may enable the constant current behavior while simultaneously achieving the three features described above.

The block diagram of FIG. 1 is not intended to indicate that the PTU 102 and/or the PRU 104 are to include all of the components shown in FIG. 1. Further, the PTU 102 and/or the PRU 104 may include any number of additional components not shown in FIG. 1, depending on the details of the specific implementation.

FIG. 2 is a schematic diagram of one embodiment of a constant current PA device 200 for wirelessly charging a battery, including a switch mode PA 116, and a matching circuit 112, which includes a low pass filter and impedance transformation arrangement 204, and a band stop/notch filter 206. The relationship between the output power and DC voltage supply of a switch mode PA at ideal operating mode can be generalized as following equation:

$$R = \alpha V^2_{DD}/P_{out}$$

Where the R represents the ideal load impedance presented to PA 116 in order to get output power of $P_{out}$, and $\alpha$ is a coefficient that varies between different switch mode PA topologies. The value of $\alpha$ may range from 0.056 for an even harmonic Class E topology to 1.356 for a parallel circuit Class E topology.

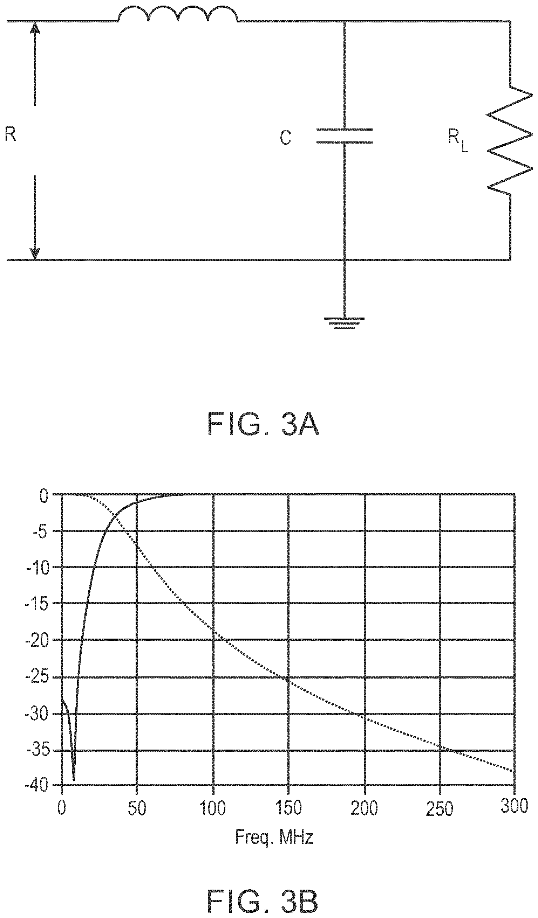

Based on the above relationship, the combined output network transforms the load impedance $R_L$ to R in order to get the desired output power on $R_L$. This can be achieved by applying a single or a combination of L network impedance transformers with low pass characteristics. For example, the LC impedance transformation circuit in FIG. 3A can be synthesized with the following equations:

$$L = RQ_L/\omega \qquad C = Q_L/R_L\omega \qquad Q_L = (R_L/R - 1)^{1/2}$$

where $\omega$ is the angular frequency. This circuit of FIG. 3A has a low pass frequency response, as shown in FIG. 3B. However the low pass frequency response may not be sharp enough to suppress the low order harmonics. Additional band rejection filtering may be used to further suppress low order harmonics.

Simply applying the impedance transformation and filter network does not guarantee a constant current behavior, as the output power characteristics depend on the topology of the switch mode PA 116. The output power characteristics can be discovered through load pull simulation at the output of the switch mode PA (e.g., reference plane A in FIG. 2).

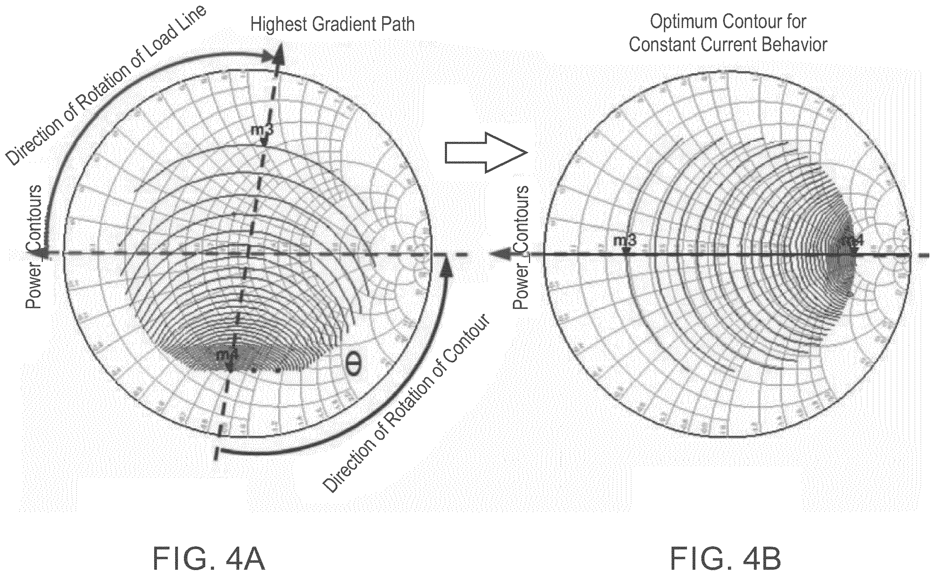

FIG. 4a depicts the constant power contour of a typical Class E PA with shunt capacitance plotted with the center of the smith chart at R. As can be seen, the constant power contour intercepts the real axis with multiple contours, which indicates that the output power first increases and then decreases as the load impedance increases. This does not translate into an overall constant current behavior.

For the best constant current behavior, as shown in FIG. 4a, the load line of increasing load resistance needs to be rotated from the real axis of the smith chart to align with the path of maximum gradient of the constant power contour of the switch mode PA. Operating along this path warrants highest rate of monotonic increase in output power along with increase of load resistance, hence the best constant current behavior possible.

To implement a load line that aligns with the identified highest gradient path of the constant power contour calls for an impedance transformation network that rotates the real axis clockwise by $\theta$, which is equivalent of rotating the constant power contour counter clockwise by $\theta$ such the maximum gradient path aligns with the real axis, as shown in FIG. 4b. This rotation maneuver on the smith chart can be interpreted as a phase shift. However, to implement the phase shift needed for constant current behavior, impedance transformation, and low pass filtering, all at the same time, calls for a carefully synthesized output network.

The LC low pass impedance transformation network shown in FIG. 3a may transform $R_L$ at the load side to R presented to the switch mode PA, where $R_L > R$. When a generalized impedance of $R_{out}$ is presented to the network, it will be transformed to $R_{out}'$ which is represented by the following expression:

$$R_{out}' = R_{out}/(1+ \omega R_{out}C)^2 + j[\omega L - \omega CR_{out}^2/(1+ \omega R_{out}C)^2]$$

On the smith chart centered at $R$, the $R'_{out}$ are located at

$$\Gamma = (R_{out}' - R)/(R_{out}' + R)$$

Substituting $L$ and $C$ by $R_L$, $R$ and $Q_L$ yields:

$$\Gamma = -(R^2_{out} - R^2_L)(R_L - 2R)/R_L(R_{out} + R_L)^2 - 2jQ_LR(R^2_{out} - R^2_L)/R_L(R_{out} + R_L)^2$$

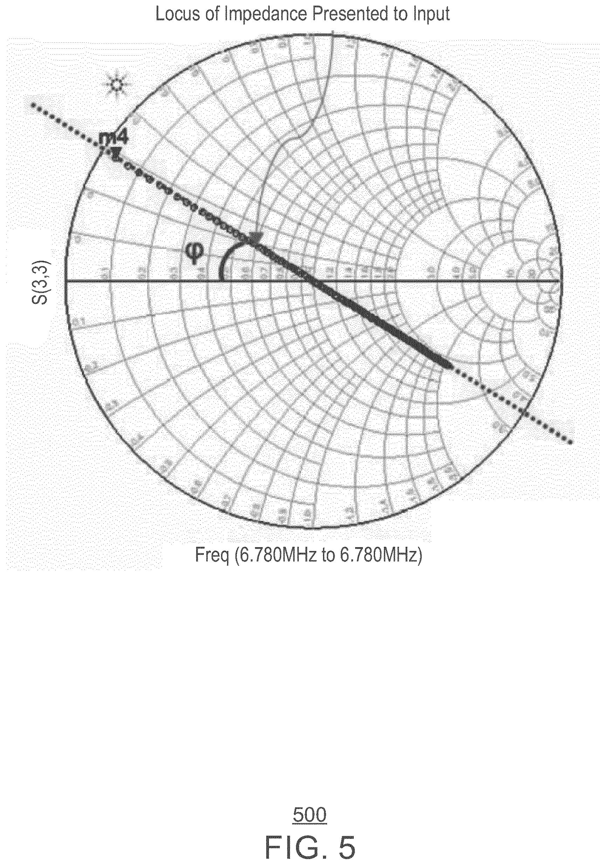

The locus of which is plotted in FIG. 5 and its angle with real axis φ on the smith chart can be calculated as:

$$\angle\Gamma = \varphi = \pi - \arctan(Im(\Gamma)/Re(\Gamma)) = \pi - \arctan(2Q_LR/(R_L - 2R)) = \pi - \arctan((R_LR - R^2)^{1/2}/(R_L - 2R))$$

As can be seen, the angle is independent of the output resistance, and it appears as a straight line on the smith chart. In other words, the LC low pass network may function as a phase shift element. As shown in FIG 5, the phase shift introduced by the LC network in FIG. 3A is plotted on the smith chart with $R$ as the origin and sweeping $R_L$. As can be seen, it has provides a clockwise rotation of φ, which corresponds to a phase shift of φ/2 as determined by the above equations. Thus, low pass filter arrangement 204 may transform the power amplifier output impedance R to match the resistive load input impedance $R_L$.

A one stage impedance transformation may not offer both the exact phase shift and the desired impedance transformation. Thus, low pass filter arrangement 204 may include a first stage low pass filter 208 and a second stage low pass filter 210. The two stage solution provides one more degree of freedom (intermediate stage impedance $R_{INT}$) to allow the PA output network to simultaneously achieve proper impedance transformation and constant current behavior. The second low pass filtering stage also improves the electro-magnetic interference (EMI) suppression.

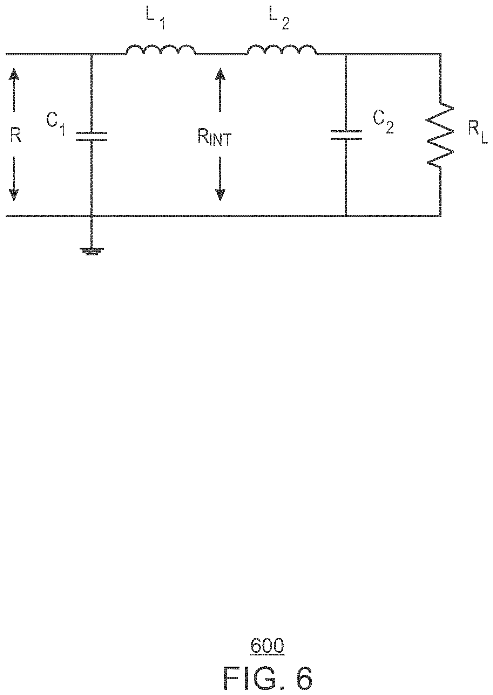

A two stage low pass impedance transformation network 400 is shown in FIG. 6 where two LC networks are used to convert load impedance of $R_L$ to match with input impedance R. An intermediate impedance of $R_{INT}$ is selected such that $R_{INT} < R_L$ and $R_{INT} < R$. The circuit parameters of the output network can be calculated as:

$$L_1 = R_{INT}Q_{L1}/\omega \qquad C_1 = Q_{L1}/R\omega \qquad Q_{L1} = (R/R_{INT} - 1)^{1/2}$$

$$L_2 = R_{INT}Q_{L2}/\omega \qquad C_2 = Q_{L2}/R_L\omega \qquad Q_{L2} = (R_L/R_{INT} - 1)^{1/2}$$

The corresponding clockwise rotation of the load line introduced by each stage can be calculated as:

$$\varphi_1 = - \arctan(2Q_{L1}R_{INT}/(R - 2R_{INT}))$$

$$\varphi_2 = \pi - \arctan(2Q_{L2}R_{INT}/(R_L - 2R_{INT}))$$

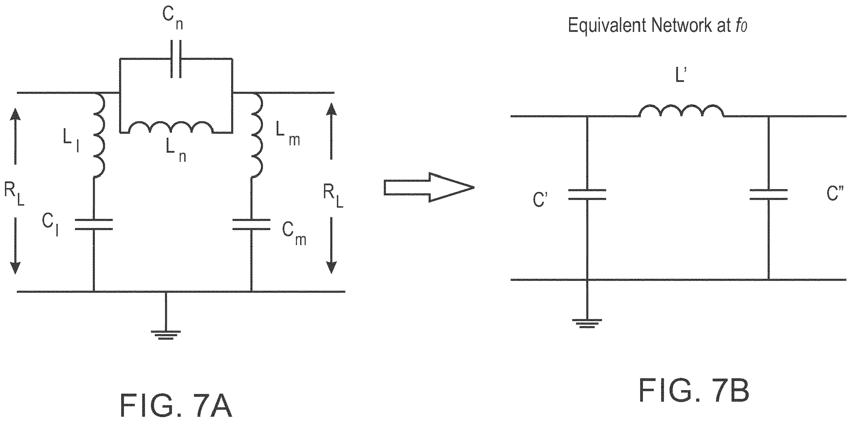

Once the input and output impedances (R, RL) are fixed, there is a unique intermediate impedance RINT that provides a desired combined phase shift (φ/2 = $\varphi_1$/2 + $\varphi_2$/2) for the PA to achieve optimum constant current behavior. The notch filter (band rejection filter) network 206 at the output of the impedance transformation network may provide added rejection of the first few harmonics. For example, the three resonance pairs can be tuned individually to resonant at l$f_0$ m$f_0$ and n$f_0$ where $f_0$ is the fundamental frequency (6.78MHz for A4WP) and the coefficients l, m, and n are integer numbers representing the $l_{th}$, $m_{th}$ and $n_{th}$ harmonics of $f_0$. As can be seen from FIGS. 7A-B, the harmonic traps equivalent to a LC π network at $f_0$. Following the previous analysis, the equivalent inductance L' and capacitance C' C" values can be adjusted through changing the Q(lmn) of the series or parallel resonance tanks such that it contributes a predetermined phase shift ρ to the load. When the input and output impedance are the same, i.e. RL, the equivalent capacitance and inductance value that offers the predefined phase shift ρ can be calculated as:

$$C' = C'' = (1 - \cos(\rho))/(R_L\omega \sin(\rho)) \qquad L' = R_L \sin(\rho)/\omega$$

The same network can also be used to carry out impedance transformation in addition to phase shift, depending on the design characteristics of a particular embodiment. In order to achieve constant current behavior, the phase shift combination of the two stage LC network ($\varphi_1$+$\varphi_2$)/2 plus the phase shift introduced by the notch filter ρ may be determined as:

$$\phi_1 + \phi_2 + 2\rho = \phi - \arctan(2Q_{L2}R_{INT}/(R_L - 2R_{INT})) - \arctan(2Q_{L1}R_{INT}/(R - 2R_{INT})) + 2\rho$$

where the Qs of the notch filter circuit can be calculated as:

$$Q_l = l\ R_L \sin(\rho)/(l^2 - 1)(1 - \cos(\rho))$$

$$Q_m = m\ R_L \sin(\rho)/(m^2 - 1)(1 - \cos(\rho))$$

$$Q_n = R_L \sin(\rho)(n^2 - 1)/n$$

This relationship may enable the switch mode PA to simultaneously achieve the desired output power at design load resistance $RL$, optimum constant current behavior and good low pass and band reject filtering in order to pass EMI.

The present disclosure describes a PA output network wherein the output network circuit parameters are selected to make the PA automatically output more power as load impedances increase, which may result in best constant current behavior. Thus, the system design is significantly simplified, reducing cost and providing better function over large load impedance range.

FIG. 8 illustrates a design flow method 800 for switch mode constant current output from a PA for an A4WP wireless charging system. In block 802, product specification, such as efficiency, cost, board area, etc., are determined. In block 804, the mode of operation of the switched mode PA (e.g., class E or class D, single ended or differential, etc,) is chosen based on the product specifications.

In a next block 806, the switch mode PA's output impedance R and the values of L and C within, or associated with, the PA are determined based on the DC supply voltage and output power, using equations provided above. For example, the desired output impedance R to present to the PA to achieve the desired power output level is calculated, and the reactance values of L and C used to support the timing of the selected operation mode can then be determined from design equations.

In block 808, a load pull simulation is run to plot the constant power contours on a smith chart, on top of which a load line can be drawn through the center of the chart to indicate the maximum gradient path of the contour. This line is the ideal load path for the overall PA to present the best constant current behavior. The slope angle $\theta$ between this line and the real axis of the smith chart indicates the ideal phase shift of the output filter and the impedance transformation network.

In block 810, low pass impedance transformer circuit topology is then selected based on $\theta$, where it could be consist of a $\pi$ network (as shown in FIG. 4), T network, other single network, or a combination of multiple LC networks. Then, in block 812, the output notch filter is defined based on the frequencies to be rejected according to an electromagnetic compatibility (EMC) evaluation. The combination of inductor and capacitor can then be designed to offer a proper phase shift.

Next, in block 814, the impedance transformer and notch filter section are optimized by adjusting the design parameters, (e.g., $R_{INT}$, Q of notch filter segments, etc.) such that the desired phase shift $\theta$ is fulfilled by the combine phase shift of the impedance transformation and filter stages. This may be an iterative process, as shown in block 816 wherein it is determined whether the combined phase shift from the output network = $\theta$. If not, operation returns to block 814. If so, the constant current switch mode PA has been optimized, as indicated in block 818. By successfully fulfilling the desired phase shift $\theta$ by the combine phase shift of the impedance transformation and filter stages, the PA may be enabled to simultaneously offer constant current behavior, desired power output and low EMI emissions.

The method 800 should not be interpreted as meaning that the blocks are necessarily performed in the order shown. Furthermore, fewer or greater actions can be included in the method 800 depending on the design considerations of a particular implementation.

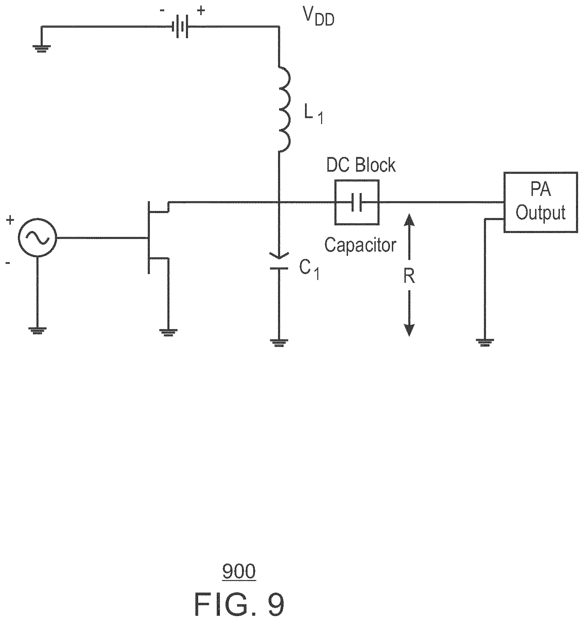

FIG. 9 illustrates a constant current PA 900 of an A4WP based wireless charging apparatus. PA 900 includes a single ended Class E topology with finite inductance and a 10.8V VDD (derived from 12VDC supply), which has a compact size and low cost. The wireless charging coil system may call for PA 900 to put out 12 Watts to a 30 Ohm load. Based on the design equation for a Class E PA of this topology, the L and C values can be calculated as:

$$R = 1.356\ V_{DD}^2/P_{out} = 13.27\ \text{Ohm}$$

$$L_1 = 0.732R/\omega = 228 \text{ nH}$$

$$C_1 = 0.985/R\omega = 1212 \text{ pF}$$

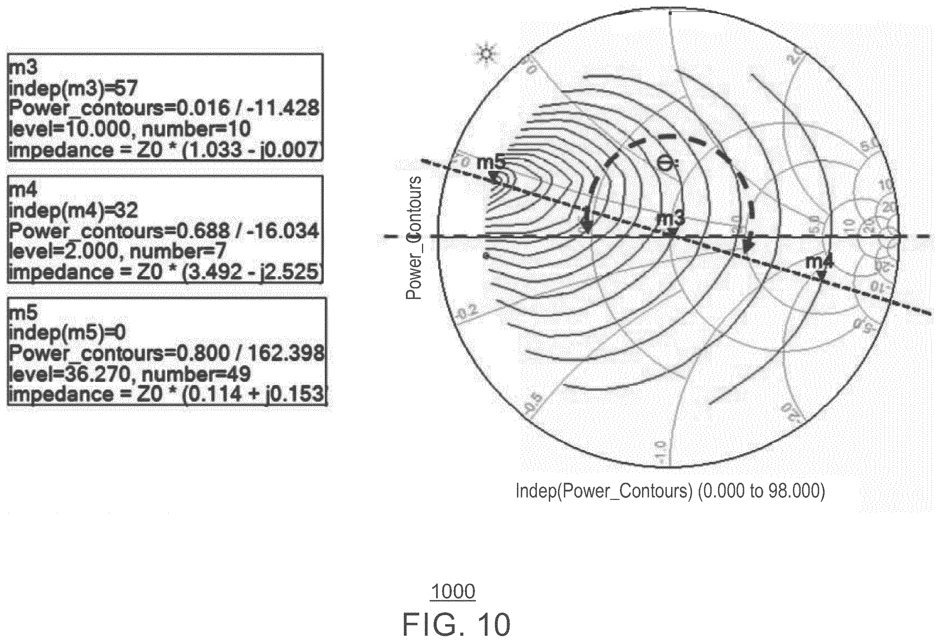

Load pull simulation of this PA structure may be carried out, and may result, as shown in FIG. 10, in an ideal load line angle of $\theta$ = 197 degrees being identified, which corresponds to a phase shift of 98.5 degrees between output of the PA and the load.

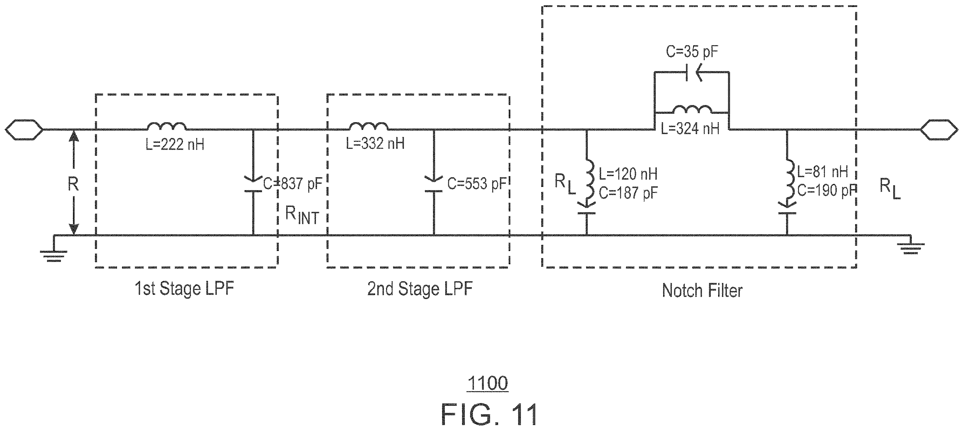

FIG. 11 illustrates a device 1100 for wirelessly charging a battery including a two stage L low pass network followed by a notch filter. The L networks transform a source impedance of 13.27 Ohms to a load impedance of 30 Ohms with an intermediate impedance of 20 Ohm. The notch filter has a characteristic impedance of 30 Ohm and rejects 5th 6th and 7th harmonics of 6.78 MHz.

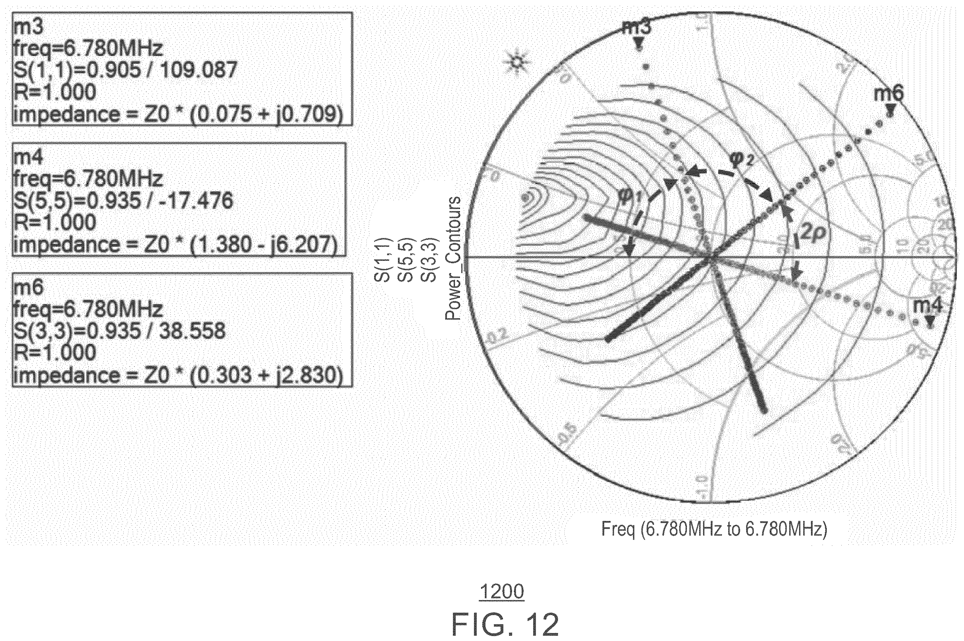

The simulated phase shift (rotation of the load line) is shown in FIG. 12. It can be seen that the two stages of the L low pass impedance transformer contribute rotation of $\phi_1$=71° and $\phi_2$=71° respectively. In order to fulfill the overall rotation of $\theta$=197°, the notch filter network may be optimized to provide a rotation of $2\rho$=55°. The corresponding Q5, Q6 and Q7 of the notch filter are 25, 20.6 and 96.6 respectively.

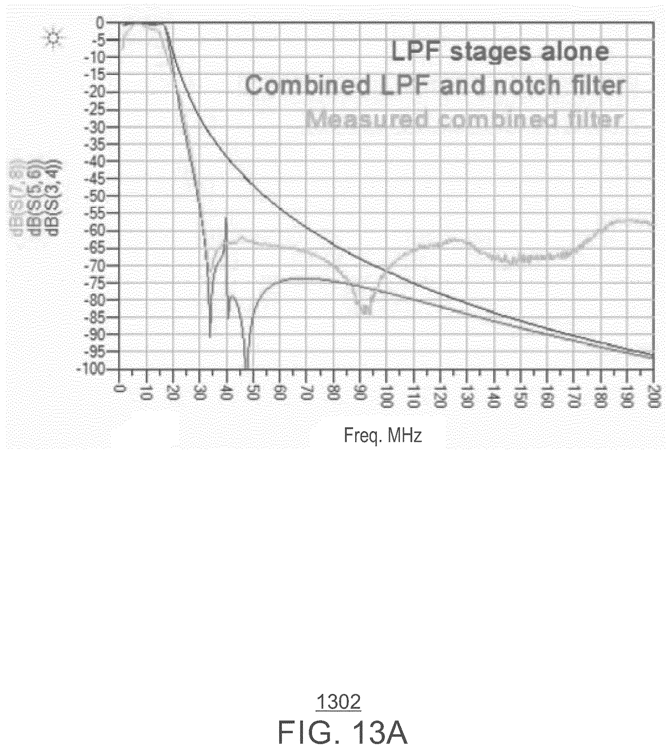

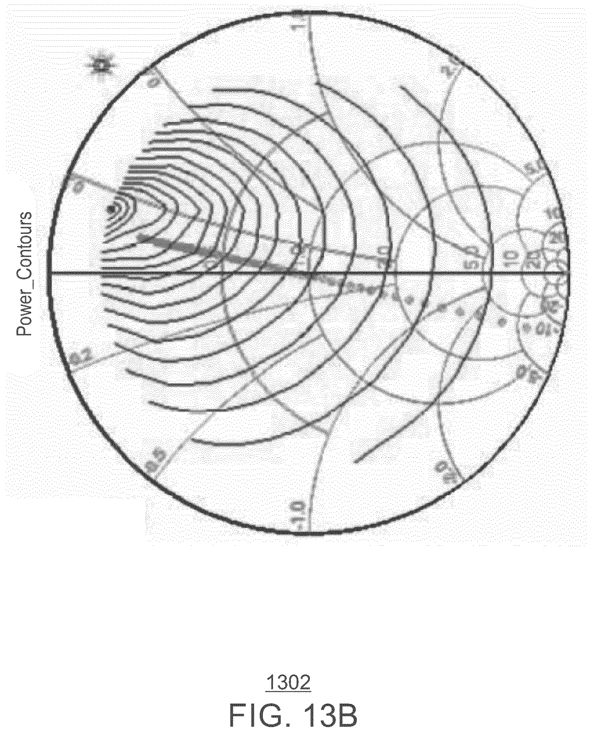

The frequency response of the combined filter network is shown in FIG. 13a. It can be seen that the plot that steadily decreases with frequency represents the low pass filter stages alone, and the plot that approaches the steadily decreasing plot represents the combined filter response where the addition of the three notch filters provides an attenuation of harmonics greater than 30MHz (starting point of EMI spurious emission tests) of at least 55dB. The third plot, which has the highest value at high frequencies, represents empirical data for a prototype of the filter circuit, and shows good agreement vs. simulation. The phase shift of the prototyped network is also measured, and the results are as shown in FIG. 13b. The direction of the load line aligns with the ideal load line very well.

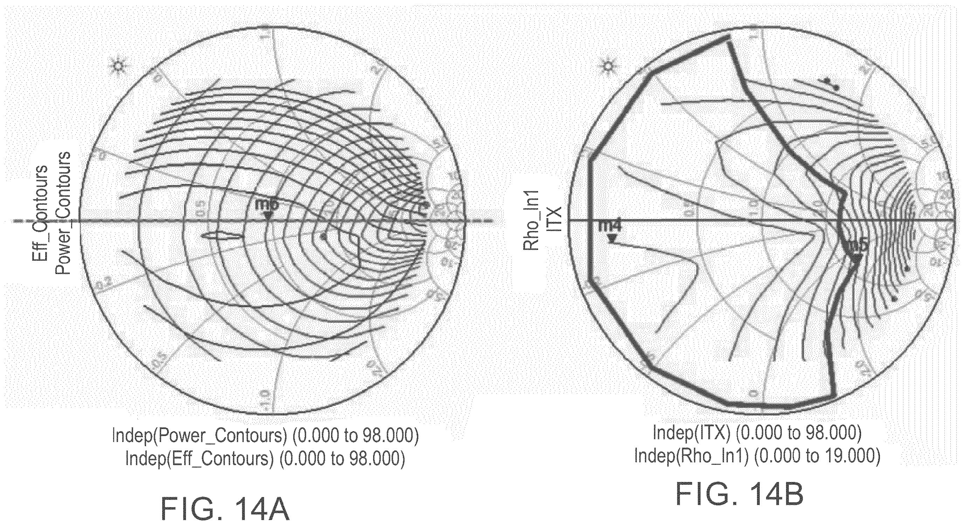

FIGS. 14a-b illustrate the simulated load pull contours after combining the switch mode PA and the synthesized output network. As shown in FIG. 14a, the PA design outputs desired power at the target impedance. Each constant power contour intercepts the real axis monotonically, which aligns well with the design goal. FIG. 14b depicts the constant current contours at the output of the filter and the required impedance range for constant current behavior based on the A4WP specification. As can be seen, although a very large range of resistance and reactance (2-50 Ohm,-54~12jOhm) is covered, the PA design in general exhibits very good constant current behavior. The variation in the impedance range is only between 740mA and 860mA peak value (or between 523mA and 608mA RMS), which is considered certifiable in terms of constant current behavior.

The PA solution has been described herein as being utilized in conjunction with a wireless charging coil. However, the inventive PA solution may also work when used in conjunction with clock generation circuitry.

*Examples*

Example 1 is a device for wirelessly charging a battery. The device includes a power amplifier comprising a transmitter coil to generate a magnetic field for wirelessly charging a battery; a low pass filter arrangement electrically coupled to an output of the power amplifier; and a band stop filter electrically coupled to an output of the low pass filter arrangement, an output of the band stop filter to electrically couple to a transmitter coil, wherein the low pass filter arrangement and the band stop filter are to transform a load impedance associated with the transmitter coil such that the power amplifier produces a current at an input of the transmitter coil that remains substantially constant in response to changes in the load impedance.

Example 2 includes the device of example 1, including or excluding optional features. In this example, the battery is associated with the transmitter coil through inductive coupling between the transmitter coil and a receiver coil and presented as a load resistance associated with the transmitter coil.

Example 3 includes the device of any one of examples 1 to 2, including or excluding optional features. In this example, the low pass filter arrangement and the band stop filter transform the load impedance associated with the transmitter coil such that the load impedance associated with the transmitter coil matches the impedance of the power amplifier when delivering desired power to the battery under charge.

Example 4 includes the device of any one of examples 1 to 3, including or excluding optional features. In this example, the low pass filter arrangement comprises a first stage low pass filter series connected to a second stage low pass filter. Optionally, the first stage low pass filter comprises a first inductor and a first capacitor, and the second stage low pass filter comprises a second inductor and a second capacitor.

Example 5 includes the device of any one of examples 1 to 4, including or excluding optional features. In this example, the power amplifier has an output impedance R, the resistive load having an input impedance $R_L$, the low pass filter arrangement providing an output voltage with a phase shift of $\varphi/2$, wherein:

$$\varphi = \pi - \arctan((R_L R - R^2)^{1/2}/(R_L - 2R)).$$

Optionally, the low pass filter arrangement is configured to transform the power amplifier output impedance R to match the resistive load impedance $R_L$.

Example 6 includes the device of any one of examples 1 to 5, including or excluding optional features. In this example, the low pass filter arrangement and the band stop filter are to filter out harmonics of the current produced at the output of the power amplifier.

Example 7 includes the device of any one of examples 1 to 6, including or excluding optional features. In this example, the second stage low pass filter interconnects the first stage low pass filter series and the band stop filter.

Example 8 includes the device of any one of examples 1 to 7, including or excluding optional features. In this example, the low pass filter arrangement and the band stop filter rotate a real axis on a smith chart clockwise and rotate a constant power contour counter clockwise such a maximum gradient path aligns with the real axis.

Example 9 includes the device of any one of examples 1 to 8, including or excluding optional features. In this example, the low pass filter arrangement and the band stop filter rotate a real axis on a smith chart clockwise by an angle $\varphi$ which corresponds to a phase shift of $\varphi/2$.

Example 10 includes the device of any one of examples 1 to 9, including or excluding optional features. In this example, the low pass filter arrangement comprises a first stage low pass filter series connected to a second stage low pass filter, the first stage low pass filter comprising a first inductor $L_1$ and a first capacitor $C_1$, and the second stage low pass filter comprises a second inductor $L_2$ and a second capacitor $C_2$, an intermediate impedance $R_{INT}$ being provided between the first stage low pass filter and the second stage low pass filter, wherein the values of $L_1$, $C_1$, $L_2$ and $C_2$, satisfy the following equations to draw substantially constant current from the power amplifier:

$$L_1 = R_{INT}Q_{L1}/\omega \qquad C_1 = Q_{L1}/R\omega \qquad Q_{L1} = (R/R_{INT} - 1)^{1/2}$$

$$L_2 = R_{INT}Q_{L2}/\omega \qquad C_2 = Q_{L2}/R_L\omega \qquad Q_{L2} = (R_L/R_{INT} - 1)^{1/2}$$

wherein $\omega$ is an angular frequency, R is an impedance at an input of the first stage low pass filter, $R_L$ is an impedance at an output of the second stage low pass filter and Q is a quality factor. Optionally, the phase shift combination of the low pass filter arrangement and the band stop filter rotates the load line on the smith chart from the real axis to the desired maximum gradient path of constant power contour through selecting the intermediate impedance $R_{INT}$ and the value of Q.

Example 11 is a method for wirelessly charging a battery. The method includes providing a power amplifier and a transmitter coil; using the transmitter coil to generate a magnetic field for wirelessly charging a battery; electrically coupling a low pass filter arrangement to an output of the power amplifier; electrically coupling a band stop filter to an output of the low pass filter arrangement; electrically coupling an output of the band stop filter to a transmitter coil associated with the battery through inductive coupling with a receiver coil; and using the low pass filter arrangement and the band stop filter to transform a load impedance associated with the transmitter coil such that the power amplifier produces a current at the an input of the transmitter coil that is substantially constant in response to changes in the load impedance.

Example 12 includes the method of example 11, including or excluding optional features. In this example, the battery is associated with the transmitter coil through inductive coupling between the transmitter coil and the receiver coil and presented as a load resistance associated with the transmitter coil.

Example 13 includes the method of any one of examples 11 to 12, including or excluding optional features. In this example, the low pass filter arrangement and the band stop filter transform a load impedance associated with the transmitter coil such that the load impedance associated with the transmitter coil matches the impedance of the power amplifier when delivering desired power to the battery under charge.

Example 14 includes the method of any one of examples 11 to 13, including or excluding optional features. In this example, the low pass filter arrangement comprises a first stage low pass filter series connected to a second stage low pass filter. Optionally, the first stage low pass filter comprises a first inductor and a first capacitor, and the second stage low pass filter comprises a second inductor and a second capacitor.

Example 15 includes the method of any one of examples 11 to 14, including or excluding optional features. In this example, the power amplifier has an output impedance R, the resistive load having an input impedance $R_L$, the method further comprising using the low pass filter arrangement to provide an output voltage with a phase shift of $\varphi/2$, wherein:

$$\varphi = \pi - \arctan((R_L R - R^2)^{1/2}/(R_L - 2R))$$

Optionally, the method includes using the low pass filter arrangement to transform the power amplifier output impedance R to match the resistive load impedance $R_L$.

Example 16 includes the method of any one of examples 11 to 15, including or excluding optional features. In this example, the low pass filter arrangement and the band stop filter are to filter out harmonics of the current produced at the output of the power amplifier.

Example 17 includes the method of any one of examples 11 to 16, including or excluding optional features. In this example, the second stage low pass filter interconnects the first stage low pass filter series and the band stop filter.

Example 18 is a device for wirelessly charging a battery. The device includes a power amplifier and a transmitter coil associated with the battery, the transmitter coil to generate a magnetic field for wirelessly charging a battery; and a filtering circuit electrically connected to an output of the power amplifier and having an output electrically connected to the transmitter coil associated with the battery through inductive coupling with a receiver coil; the filtering circuit including a series combination of a band stop filter, a first stage low pass filter, and a second stage low pass filter, the series combination of a band stop filter, a first stage low pass filter, and a second stage low pass filter transforming a load impedance associated with the transmitter coil such that the power amplifier produces a current at the output of the power amplifier that is substantially constant in response to changes in the load impedance.

Example 19 includes the device of example 18, including or excluding optional features. In this example, the battery is associated with the transmitter coil through inductive coupling between the transmitter coil and the receiver coil and presented as a load resistance associated with the transmitter coil.

Example 20 includes the device of any one of examples 18 to 19, including or excluding optional features. In this example, the series combination of a band stop filter, a first stage low pass filter, and a second stage low pass filter transform a load impedance associated with the transmitter coil such that the load impedance associated with the transmitter coil matches the impedance of the power amplifier when delivering desired power to the battery under charge.

Example 21 includes the device of any one of examples 18 to 20, including or excluding optional features. In this example, the first stage low pass filter includes a first inductor and a first capacitor, and the second stage low pass filter includes a second inductor and a second capacitor.

Example 22 includes the device of any one of examples 18 to 21, including or excluding optional features. In this example, the power amplifier has an output impedance R, the resistive load having an input impedance $R_L$, the series combination of a band stop filter, a first stage low pass filter, and a second stage low pass filter being configured to provide an output voltage with a phase shift of $\varphi/2$, wherein:

$$\varphi = \pi - \arctan((R_L R - R^2)^{1/2}/(R_L - 2R))$$

Optionally, the series combination of a band stop filter, a first stage low pass filter, and a second stage low pass filter transforms the power amplifier output impedance R to match the resistive load impedance $R_L$.

Example 23 includes the device of any one of examples 18 to 22, including or excluding optional features. In this example, the series combination of a band stop filter, a first stage low pass filter, and a second stage low pass filter is to filter out harmonics of the current produced at the output of the power amplifier. Example 24 includes the device of any one of examples 18 to 23, including or excluding optional features. In this example, the second stage low pass filter interconnects the first stage low pass filter series and the band stop filter.

Example 25 is an apparatus for wirelessly charging a battery of an electronic device. The apparatus includes means for delivering current to a transmitter coil to generate a magnetic field for wirelessly charging a battery; and means for transforming a load impedance associated with the transmitter coil such that the current delivered to the transmitter coil remains substantially constant in response to changes in the load impedance without the use of a feedback circuit.

Example 26 includes the apparatus of example 25, including or excluding optional features. In this example, the means for transforming the load impedance associated with the transmitter coil comprises a low pass filter means and a band stop filter means, the low pass filter means and the band stop filter means disposed between the transmitter coil and the means for delivering current to a transmitter coil. Optionally, the low pass filter means comprises a first stage low pass filter series connected to a second stage low pass filter. Optionally, the first stage low pass filter means comprises a first inductor and a first capacitor, and the second stage low pass filter comprises a second inductor and a second capacitor. Optionally, the low pass filter means is to provide an output voltage with a phase shift of $\varphi/2$, wherein:

$$\varphi = \pi - \arctan((R_L R - R^2)^{1/2}/(R_L - 2R))$$

In the above equation, R is the output impedance of the power amplifier, and $R_L$ is load impedance associated with the transmitter coil.

Example 27 includes the apparatus of any one of examples 25 to 26, including or excluding optional features. In this example, the means for transforming the load impedance associated with the transmitter coil is to filter out harmonics of the current produced at the output of the means for delivering current to the transmitter coil.

Example 28 is a device for wirelessly charging a battery. The device includes a transmitter coil to generate a magnetic field for wirelessly charging a battery; a power amplifier to deliver current to the transmitter coil; and an impedance matching circuit to transform a load impedance associated with the transmitter coil without the use of feedback circuit such that the power amplifier produces a current at an input of the transmitter coil that remains substantially constant in response to changes in the load impedance.

Example 29 includes the device of example 28, including or excluding optional features. In this example, the impedance matching circuit transforms the load impedance associated with the transmitter coil such that the load impedance associated with the transmitter coil matches the impedance of the power amplifier when delivering desired power to the battery under charge.

Example 30 includes the device of any one of examples 28 to 29, including or excluding optional features. In this example, the impedance matching circuit comprises: a low pass filter arrangement electrically coupled to an output of the power amplifier; and a band stop filter electrically coupled to an output of the low pass filter arrangement, an output of the band stop filter to electrically couple to a transmitter coil. Optionally, the low pass filter arrangement comprises a first stage low pass filter series connected to a second stage low pass filter. Optionally, the low pass filter arrangement provides an output voltage with a phase shift of $\varphi/2$, wherein:

$$\varphi = \pi - \arctan((R_L R - R^2)^{1/2}/(R_L - 2R))$$

In the above equation, R is the output impedance of the power amplifier, and $R_L$ is load impedance associated with the transmitter coil. Optionally, the low pass filter arrangement is configured to transform the power amplifier output impedance R to match the resistive load impedance $R_L$.

Example 31 includes the device of any one of examples 28 to 30, including or excluding optional features. In this example, the impedance matching circuit is to filter out harmonics of the current produced at the output of the power amplifier.

Not all components, features, structures, characteristics, etc. described and illustrated herein need be included in a particular aspect or aspects. If the specification states a component, feature, structure, or characteristic "may", "might", "can" or "could" be included, for example, that particular component, feature, structure, or characteristic is not required to be included. If the specification or claim refers to "a" or "an" element, that does not mean there is only one of the element. If the specification or claims refer to "an additional" element, that does not preclude there being more than one of the additional element.

It is to be noted that, although some aspects have been described in reference to particular implementations, other implementations are possible according to some aspects. Additionally, the arrangement and/or order of circuit elements or other features illustrated in the drawings and/or described herein need not be arranged in the particular way illustrated and described. Many other arrangements are possible according to some aspects.

In each system shown in a figure, the elements in some cases may each have a same reference number or a different reference number to suggest that the elements represented could be different and/or similar. However, an element may be flexible enough to have different implementations and work with some or all of the systems shown or described herein. The various elements shown in the figures may be the same or different. Which one is referred to as a first element and which is called a second element is arbitrary.

It is to be understood that specifics in the aforementioned examples may be used anywhere in one or more aspects. For instance, all optional features of the computing device described above may also be implemented with respect to either of the methods or the computer-readable medium described herein. Furthermore, although flow diagrams and/or state diagrams may have been used herein to describe aspects, the techniques are not limited to those diagrams or to corresponding descriptions herein. For example, flow need not move through each illustrated box or state or in exactly the same order as illustrated and described herein.

The present techniques are not restricted to the particular details listed herein. Indeed, those skilled in the art having the benefit of this disclosure will appreciate that many other variations from the foregoing description and drawings may be made within the scope of the present techniques. Accordingly, it is the following claims including any amendments thereto that define the scope of the present techniques.

**Claims**

1. A device for wirelessly charging a battery (136), comprising:

   a power amplifier (116),
   a transmitter coil (106) to generate a magnetic field for wirelessly charging a battery (136);
   a low pass filter arrangement (204) electrically coupled to an output of the power amplifier (116); and
   a band stop filter (206) electrically coupled to an output of the low pass filter arrangement (204) comprising an output to electrically couple to the transmitter coil (106),
   **characterized in that** the low pass filter arrangement (204) and the band stop filter (206) are configured to transform a load impedance associated with the transmitter coil (106) to reduce current variations at an input of the transmitter coil (106) resulting from changes in the load impedance, and wherein to transform the load impedance associated with the transmitter coil, the low pass filter arrangement (204) and the band stop filter (206) are configured to align a maximum gradient path of a constant output power contour of the power amplifier with a real axis of an impedance smith chart.

2. The device of claim 1, wherein the low pass filter arrangement (204) and the band stop filter (206) are configured to transform the load impedance associated with the transmitter coil (106) to match the load impedance associated with the transmitter coil with the impedance of the power amplifier (116) when delivering desired power to the battery (136) under charge.

3. The device of any one of claims 1 to 2, wherein the low pass filter arrangement (204) comprises a first stage low pass filter (208) series connected to a second stage low pass filter (210).

4. The device of claim 3, the first stage low pass filter (208) comprises a first inductor and a first capacitor, and the second stage low pass filter (210) comprises a second inductor and a second capacitor.

5. The device of any one of claims 1 to 4, wherein the power amplifier (116) has an output impedance R and the low pass filter arrangement (204) provides an output voltage with a phase shift of $\varphi/2$, wherein

$$\varphi = \pi - \arctan((R_L R^2)^{1/2}/(R_L - 2R))$$

wherein $R_L$ is the load impedance associated with the transmitter coil (106).

6. The device of claim 5, wherein the low pass filter arrangement (204) is configured to transform the power amplifier output impedance R to match the load impedance $R_L$.

7. A method for wirelessly charging a battery (136), comprising:

   providing a power amplifier (116) and a transmitter coil (106);
   using the transmitter coil (106) to generate a magnetic field for wirelessly charging a battery (136);
   electrically coupling a low pass filter arrangement (204) to an output of the power amplifier (116);
   electrically coupling a band stop filter (206) to an output of the low pass filter arrangement (204);
   electrically coupling an output of the band stop filter (206) to a transmitter coil (106) associated with the battery (136) through inductive coupling with a receiver coil (108); and
   using the low pass filter arrangement (204) and the band stop filter (206) to transform a load impedance associated with the transmitter coil (106) to reduce current variations at the an input of the transmitter coil (106) resulting from changes in the load impedance, wherein to transform the load impedance associated with the transmitter coil is to align a maximum gradient path of a constant output power contour of the power amplifier with a real axis of an impedance smith chart.

8. The method of claim 7, wherein the battery (136) is associated with the transmitter coil (106) through inductive coupling between the transmitter coil (106) and the receiver coil (108) and presented as a load resistance associated with the transmitter coil (106).

9. The method of claim 7 or 8, wherein the low pass filter arrangement and the band stop filter (206) are configured to transform a load impedance associated with the transmitter coil (106) to match the load impedance associated with the transmitter coil (106) with the impedance of the power amplifier (116) when delivering desired power to the battery (136) under charge.

10. The method of any one of claims 7 to 9, wherein the low pass filter arrangement (204) comprises a first stage low pass filter (208) series connected to a second stage low pass filter (210).

**Patentansprüche**

1. Vorrichtung zum drahtlosen Laden einer Batterie (136), die Folgendes umfasst:

einen Leistungsverstärker (116),
eine Sendespule (106), um ein Magnetfeld zum drahtlosen Laden einer Batterie (136) zu erzeugen;
eine Tiefpassfilteranordnung (204), die an den Ausgang des Leistungsverstärkers (116) elektrisch gekoppelt ist; und
ein Bandsperrfilter (206), das an einen Ausgang der Tiefpassfilteranordnung (204) elektrisch gekoppelt ist, der einen Ausgang umfasst, um an die Sendespule (106) elektrisch zu koppeln,
**dadurch gekennzeichnet, dass** die Tiefpassfilteranordnung (204) und das Bandsperrfilter (206) konfiguriert sind, eine Lastimpedanz zu transformieren, die der Sendespule (106) zugeordnet ist, um Stromschwankungen an einem Eingang der Sendespule (106) zu reduzieren, die aus Änderungen in der Lastimpedanz resultieren, und wobei, um die Lastimpedanz, die der Sendespule (106) zugeordnet ist, zu transformieren, die Tiefpassfilteranordnung (204) und das Bandsperrfilter (206) konfiguriert sind, einen maximalen Gradientenweg einer konstanten Ausgangsleistungskontur des Leistungsverstärkers auf eine reale Achse eines Impedanz-Smith-Diagramms auszurichten.

2. Vorrichtung nach Anspruch 1, wobei die Tiefpassfilteranordnung (204) und das Bandsperrfilter (206) konfiguriert sind, die Lastimpedanz zu transformieren, die der Sendespule (106) zugeordnet ist, um die Lastimpedanz, die der Sendespule (106) zugeordnet ist, auf die Impedanz des Leistungsverstärkers (116) abzustimmen, wenn die gewünschte Leistung zu der zu ladenden Batterie (136) geliefert wird.

3. Vorrichtung nach einem der Ansprüche 1 bis 2, wobei die Tiefpassfilteranordnung (204) ein Tiefpassfilter (208) der ersten Stufe, das mit einem Tiefpassfilter (210) der zweiten Stufe in Reihe geschaltet ist, umfasst.

4. Vorrichtung nach Anspruch 3, wobei das Tiefpassfilter (208) der ersten Stufe eine erste Induktivität und einen ersten Kondensator umfasst, und das Tiefpassfilter (210) der zweiten Stufe eine zweite Induktivität und einen zweiten Kondensator umfasst.

5. Vorrichtung nach einem der Ansprüche 1 bis 4, wobei der Leistungsverstärker (116) eine Ausgangsimpedanz R besitzt und die Tiefpassfilteranordnung (204) eine Ausgangsspannung mit einer Phasenverschiebung von $\varphi/2$ bereitstellt, wobei

$$\varphi = \pi - \arctan\ (R_L R^2)^{1/2}\ /\ (R_L - 2R)\ \text{gilt,}$$

wobei $R_L$ der Lastimpedanz entspricht, die der Sendespule (106) zugeordnet ist.

6. Vorrichtung nach Anspruch 5, wobei die Tiefpassfilteranordnung (204) konfiguriert ist, die Leistungsverstärkerausgangsimpedanz R zu transformieren, so dass sie mit der Lastimpedanz $R_L$ übereinstimmt.

**7.** Verfahren zum drahtlosen Laden einer Batterie (136), das Folgendes umfasst:

Bereitstellen eines Leistungsverstärkers (116) und einer Sendespule (106);
Verwenden der Sendespule (106), um ein Magnetfeld zum drahtlosen Laden einer Batterie (136) zu erzeugen;
elektrisches Koppeln einer Tiefpassfilteranordnung (204) an einen Ausgang des Leistungsverstärkers (116);
elektrisches Koppeln eines Bandsperrfilters (206) an einen Ausgang der Tiefpassfilteranordnung (204);
elektrisches Koppeln eines Ausgangs des Bandsperrfilters (206) an eine Sendespule (106), die der Batterie (136) zugeordnet ist, durch induktives Koppeln mit einer Empfängerspule (108); und
**gekennzeichnet durch**
Verwenden der Tiefpassfilteranordnung (204) und des Bandsperrfilters (206), um eine Lastimpedanz, die der Sendespule (106) zugeordnet ist, zu transformieren, um Stromschwankungen an dem Eingang der Sendespule (106), die aus Änderungen in der Lastimpedanz resultieren, zu verringern, wobei zum Transformieren der Lastimpedanz, die der Sendespule zugeordnet ist, ein maximaler Gradientenweg einer konstanten Ausgangsleistungskontur des Leistungsverstärkers auf eine reale Achse eines Impedanz-Smith-Diagramms ausgerichtet werden muss.

**8.** Verfahren nach Anspruch 7, wobei die Batterie (136) der Sendespule (106) durch induktives Koppeln zwischen der Sendespule (106) und der Empfängerspule (108) zugeordnet wird und als ein Lastwiderstand dargestellt wird, der der Sendespule (106) zugeordnet ist.

**9.** Verfahren nach Anspruch 7 oder 8, wobei die Tiefpassfilteranordnung und das Bandsperrfilter (206) konfiguriert sind, eine Lastimpedanz, die der Sendespule (106) zugeordnet ist, zu transformieren, um die Lastimpedanz, die der Sendespule (106)zugeordnet ist, auf die Impedanz des Leistungsverstärkers (116) abzustimmen, wenn sie die gewünschte Leistung zu der zu ladenden Batterie (136) liefert.

**10.** Verfahren nach einem der Ansprüche 7 bis 9, wobei die Tiefpassfilteranordnung (204) ein Tiefpassfilter (208) der ersten Stufe umfasst, das mit einem Tiefpassfilter (210) der zweiten Stufe in Reihe geschaltet ist.

**Revendications**

**1.** Dispositif destiné au chargement sans fil d'une batterie (136), comprenant :

un amplificateur de puissance (116),
une bobine émettrice (106) pour générer un champ magnétique pour le chargement sans fil d'une batterie (136) ;
un agencement de filtre passe-bas (204) couplé électriquement à une sortie de l'amplificateur de puissance (116) ; et
un filtre coupe-bande (206) électriquement couplé à une sortie de l'agencement de filtre passe-bas (204) comprenant une sortie pour un couplage électrique à la bobine émettrice (106),
**caractérisé en ce que** l'agencement de filtre passe-bas (204) et le filtre coupe-bande (206) sont configurés pour transformer une impédance de charge associée à la bobine émettrice (106) afin de réduire des variations de courant à une entrée de la bobine émettrice (106) résultant de changements de l'impédance de charge, et dans lequel, pour la transformation de l'impédance de charge associée à la bobine émettrice, l'agencement de filtre passe-bas (204) et le filtre coupe-bande (206) sont configurés pour aligner un trajet de gradient maximum d'un profil de puissance de sortie constante de l'amplificateur de puissance sur un axe réel d'un abaque de Smith de l'impédance.

**2.** Dispositif selon la revendication 1, dans lequel l'agencement de filtre passe-bas (204) et le filtre coupe-bande (206) sont configurés pour transformer l'impédance de charge associée à la bobine émettrice (106) afin de faire correspondre l'impédance de charge associée à la bobine émettrice à l'impédance de l'amplificateur de puissance (116) lorsqu'une puissance souhaitée est fournie à la batterie (136) en charge.

**3.** Dispositif selon l'une quelconque des revendications 1 à 2, dans lequel l'agencement de filtre passe-bas (204) comprend un filtre passe-bas primaire (208) connecté en série à un filtre passe-bas secondaire (210).

**4.** Dispositif selon la revendication 3, dans lequel le filtre passe-bas primaire (208) comprend une première bobine d'induction et un premier condensateur, et le filtre passe-bas secondaire (210) comprend une deuxième bobine d'induction et un deuxième condensateur.

5. Dispositif selon l'une quelconque des revendications 1 à 4, dans lequel l'amplificateur de puissance (116) présente une impédance de sortie R et l'agencement de filtre passe-bas (204) fournit une tension de sortie avec un déphasage de φ/2, où

$$\varphi = \pi - \arctan (R_L R^2)^{1/2} / (R_L - 2R)$$

$R_L$ étant l'impédance de charge associée à la bobine émettrice (106).

6. Dispositif selon la revendication 5, dans lequel l'agencement de filtre passe-bas (204) est configuré pour transformer l'impédance de sortie R de l'amplificateur de puissance pour qu'elle corresponde à l'impédance de charge $R_L$.

7. Procédé destiné au chargement sans fil d'une batterie (136), comprenant les étapes consistant à :

prévoir un amplificateur de puissance (116) et une bobine émettrice (106) ;
utiliser la bobine émettrice (106) pour générer un champ magnétique pour le chargement sans fil d'une batterie (136) ;
coupler électriquement un agencement de filtre passe-bas (204) à une sortie de l'amplificateur de puissance (116) ;
coupler électriquement un filtre coupe-bande (206) à une sortie de l'agencement de filtre passe-bas (204) ;
coupler électriquement une sortie du filtre coupe-bande (206) à une bobine émettrice (106) associée à la batterie (136) à travers un couplage inductif avec une bobine réceptrice (108) ; et
**caractérisé par** l'utilisation de l'agencement de filtre passe-bas (204) et du filtre coupe-bande (206) pour transformer une impédance de charge associée à la bobine émettrice (106) afin de réduire des variations de courant à l'entrée de la bobine émettrice (106) résultant de changements de l'impédance de charge, et dans lequel la transformation de l'impédance de charge associée à la bobine émettrice correspond à l'alignement d'un trajet de gradient maximum d'un profil de puissance de sortie constante de l'amplificateur de puissance sur un axe réel d'un abaque de Smith de l'impédance.

8. Procédé selon la revendication 7, dans lequel la batterie (136) est associée à la bobine émettrice (106) par un couplage inductif entre la bobine émettrice (106) et la bobine réceptrice (108) et présentée comme une résistance de charge associée à la bobine émettrice (106).

9. Procédé selon la revendication 7 ou 8, dans lequel l'agencement de filtre passe-bas et le filtre coupe-bande (206) sont configurés pour transformer une impédance de charge associée à la bobine émettrice (106) afin de faire correspondre l'impédance de charge associée à la bobine émettrice (106) à l'impédance de l'amplificateur de puissance (116) lorsqu'une puissance souhaitée est fournie à la batterie (136) en charge.

10. Procédé selon l'une quelconque des revendications 7 à 9, dans lequel l'agencement de filtre passe-bas (204) comprend un filtre passe-bas primaire (208) connecté en série à un filtre passe-bas secondaire (210).

EP 3 148 045 B1

100

FIG. 1

FIG. 2

FIG. 3A

FIG. 3B

FIG. 4A

FIG. 4B

EP 3 148 045 B1

Locus of Impedance Presented to Input

Freq (6.780MHz to 6.780MHz)

500

FIG. 5

$L_1$

$L_2$

$R$

$C_1$

$R_{INT}$

$C_2$

$R_L$

<u>600</u>

FIG. 6

Equivalent Network at $f_0$

FIG. 7B

FIG. 7A

21

800

FIG. 8

900

FIG. 9

FIG. 10

1000

Indep(Power_Contours) (0.000 to 98.000)

Power_Contours

m3
indep(m3)=57
Power_contours=0.016 / -11.428
level=10.000, number=10
impedance = Z0 * (1.033 - j0.007)

m4
indep(m4)=32
Power_contours=0.688 / -16.034
level=2.000, number=7
impedance = Z0 * (3.492 - j2.525)

m5
indep(m5)=0
Power_contours=0.800 / 162.398
level=36.270, number=49
impedance = Z0 * (0.114 + j0.153)

FIG. 11

1100

1st Stage LPF — L=222 nH, C=837 pF, $R_{INT}$

2nd Stage LPF — L=332 nH, C=553 pF

Notch Filter — C=35 pF, L=324 nH, L=81 nH, C=190 pF, L=120 nH, C=187 pF, $R_L$, $R_L$, R

FIG. 12

1200

Freq (6.780MHz to 6.780MHz)

Power_Contours
S(3,3)
S(5,5)
S(1,1)

m3
freq=6.780MHz
S(1,1)=0.905 / 109.087
R=1.000
impedance = Z0 * (0.075 + j0.709)

m4
freq=6.780MHz
S(5,5)=0.935 / -17.476
R=1.000
impedance = Z0 * (1.380 - j6.207)

m6
freq=6.780MHz
S(3,3)=0.935 / 38.558
R=1.000
impedance = Z0 * (0.303 + j2.830)

LPF stages alone
Combined LPF and notch filter
Measured combined filter

Freq. MHz

1302

FIG. 13A

1302

FIG. 13B

Eff_Contours
Power_Contours

m6

Indep(Power_Contours) (0.000 to 98.000)
Indep(Eff_Contours) (0.000 to 98.000)

FIG. 14A

Rho_In1
ITX

m4

m5

Indep(ITX) (0.000 to 98.000)
Indep(Rho_In1) (0.000 to 19.000)

FIG. 14B

**REFERENCES CITED IN THE DESCRIPTION**

**Patent documents cited in the description**

- US 2015069854 A1
- US 2013187712 A1
- US 2014091634 A1
- US 2008180170 A1